# EUROPÄISCHE PATENTSCHRIFT

(11) **EP 2 036 118 B1**
(45) Veröffentlichungstag und Bekanntmachung des Hinweises auf die Patenterteilung: **26.08.2015**
(21) Anmeldenummer: 07728627.6
(22) Anmeldetag: 27.04.2007
(51) Int. Cl.: H01L 21/20, H01L 21/36

(54) **VERFAHREN ZUR HERSTELLUNG EINES SILIZIUMSUBSTRATS MIT VERÄNDERTEN OBERFLÄCHENEIGENSCHAFTEN**
METHOD FOR PRODUCING A SILICON SUBSTRATE HAVING MODIFIED SURFACE PROPERTIES
PROCÉDÉ DE PRODUCTION D'UN SUBSTRAT DE SILICIUM À PROPRIÉTÉS DE SURFACE MODIFIÉES

(30) Priorität: 23.06.2006 DE 102006028921
(43) Veröffentlichungstag der Anmeldung: 18.03.2009
(73) Patentinhaber: Robert Bosch GmbH, 70442 Stuttgart (DE)
(72) Erfinder: BENZEL, Hubert, 72124 Pliezhausen (DE); ILLING, Matthias, 72127 Kusterdingen (DE); LAERMER, Franz, 71263 Weil der Stadt (DE); KRONMUELLER, Silvia, 71409 Schwaikheim (DE); FARBER, Paul, 70193 Stuttgart (DE); ARMBRUSTER, Simon, 72810 Gomaringen (DE); LAMMEL, Gerhard, 72070 Tuebingen (DE); REICHENBACH, Ralf, 73732 Esslingen (DE); SCHELLING, Christoph, 70597 Stuttgart (DE); FEYH, Ando, 71732 Tamm (DE)
(86) Internationale Anmeldenummer: PCT/EP2007/054172
(87) Internationale Veröffentlichungsnummer: WO 2007/147670

(56) Entgegenhaltungen:
- JP-A- 11 017 217
- US-A1- 2005 263 754
- HENLEY W ET AL: "Infrared photoluminescence from Er doped porous Si" JOURNAL OF APPLIED PHYSICS, AMERICAN INSTITUTE OF PHYSICS. NEW YORK, US, Bd. 87, Nr. 11, 1. Juni 2000 (2000-06-01), Seiten 7848-7852, XP012049168 ISSN: 0021-8979
- "Spin-on doping of porous silicon and its effect on photoluminescence and transport characteristics" APPLIED PHYSICS LETTERS, AIP, AMERICAN INSTITUTE OF PHYSICS, MELVILLE, NY, US, Bd. 70, Nr. 17, 28. April 1997 (1997-04-28), Seiten 2253-2255, XP012017698 ISSN: 0003-6951
- T. P. NGUYEN ET AL.: "Non-linear optical properties of poly(phenylene vinylene) in porous silicon substrates" PHYSICA STATUS SOLIDI C, Bd. 2, Nr. 9, 2005, Seiten 3222-3226, XP009088962
- RAISSI F ET AL: "Highly sensitive near IR detectors using n-type porous Si" SENSORS AND ACTUATORS A, ELSEVIER SEQUOIA S.A., LAUSANNE, CH, Bd. 104, Nr. 2, 15. April 2003 (2003-04-15), Seiten 117-120, XP004417424 ISSN: 0924-4247

## Beschreibung

### Stand der Technik

Die vorliegende Erfindung betrifft ein Verfahren zur Herstellung eines Siliziumsubstrats, insbesondere eines Siliziumwafers, mit veränderten Materialeigenschaften an der Oberfläche des Siliziumsubstrats. Ferner betrifft die vorliegende Erfindung ein Siliziumsubstrat, insbesondere einen Siliziumwafer, welcher nach dem erfindungsgemäßen Verfahren hergestellt wurde.

Verfahren zur Herstellung von Siliziumsubstraten sind aus dem Stand der Technik in unterschiedlichen Ausgestaltungen bekannt. Im Allgemeinen werden Materialeigenschaften von Silizium durch Diffusion von Fremdatomen in das Silizium, ausgehend von der Substratoberfläche, bewirkt. Hierbei wird beispielsweise ein Dotierstoff auf der Substratoberfläche abgeschieden und danach bei sehr hoher Temperatur thermisch in das Silizium eingetrieben. Das heißt, die Dotierstoffe werden zur Diffusion in das Silizium angeregt.

Ferner ist aus der EP 0 750 058 B1 ein Verfahren zum Dotieren eines kristallinen Substrats bekannt, bei welchem zuerst eine erste Schicht auf dem Substrat erzeugt wird, welche Fehlstellen aufweist. Anschließend wird eine zweite Schicht auf der ersten Schicht aufgebracht, die von der ersten Schicht getrennt ist. Die zweite Schicht enthält Dotierstoffatome, welche veranlasst werden, in die erste beschädigte Schicht zu diffundieren und in der ersten Schicht die Fehlstellen zu besetzen. Anschließend wird die zweite Schicht entfernt.

Die JP 11017217 A offenbart die Herstellung eines Licht-emittierenden Elements durch Einfüllen seltener Erden in ein Siliziumsubstrat.

Henley et al. "Infrared photoluminescence from Er doped porous Si", Journal of Applied Physics, Volume 87, Number 11, zeigen die Fertigung von Siliziumsubstraten, wobei Erbium in poröses Silizium eingearbeitet wird.

Sen et al. "Spin-on doping of porous silicon and its effect on photoluminescence and transport characteristics", Appl. Phys. Letter, Volume 70, Number 17, beschreiben die Dotierung von porösen Siliziumschichten.

Die US 20050263754 A1 offenbart ein Substrat zum Wachstum von chemischen Verbundhalbleitern.

Nguyen et al. "Non-linear optical properties of poly (phenylene vinylene) in porous silicon substrates", Phys. Stat. Sol. Volume 2, Number 9, beschreiben, wie poröse silizium schichten mit Materialien gefüllt werden können.

Raissi und Sheeni "Highly sensitive near IR detectors using n-type porous Si", Sensors and Actuators A, Volume 104, (2003), 117-120, beschreiben wie poröses Silizium zur Herstellung von Platinsilizium Schottky Detektoren verwendet wird.

Die bekannten Verfahren weisen jedoch den Nachteil auf, dass die Diffusionsvorgänge auch bei sehr hohen Temperaturen nur sehr langsam stattfinden. Daher können mit den bekannten Verfahren Fremdstoffe nur in Tiefen von maximal 20 bis 25 µm in das Silizium eingebracht werden. Ferner gibt es auch Fremdatome, wie z.B. Antimon (Sb) oder Germanium (Ge), welche aufgrund ihrer großen Atomdurchmesser nur extrem langsam diffundieren. Somit kann eine hinreichende Diffusionstiefe innerhalb von wirtschaftlich vertretbaren Zeiten nicht erreicht werden.

### Vorteile der Erfindung

Das erfindungsgemäße Verfahren mit den Merkmalen des Patentanspruchs 1 weist demgegenüber den Vorteil auf, dass es möglich ist, Siliziummaterialien mit veränderten Eigenschaften herzustellen. Die Eigenschaften können dabei gezielt verändert werden. Erfindungsgemäß werden hierbei insbesondere Nanopartikel in das Siliziumsubstrat eingebracht, wobei das erfindungsgemäße Verfahren sehr wirtschaftlich und kostengünstig durchgeführt werden kann. Dies wird erfindungsgemäß dadurch erreicht, dass eine poröse Siliziumoberfläche hergestellt wird, welche Makroporen mit einem Durchmesser zwischen 10 µm bis 50 nm, oder Mesoporen mit einem Durchmesser zwischen 50 nm bis 2 nm oder Nanoporen mit einem Durchmesser kleiner 2 nm hergestellt wird. Anschließend wird ein in die Siliziumoberfläche einzubringendes Füllmaterial aufgebracht und das Füllmaterial in die erzeugten Poren der Siliziumoberfläche eingefüllt. Anschließend wird gegebenenfalls überflüssiges Füllmaterial von der Siliziumoberfläche entfernt und das Siliziumsubstrat mit dem Füllmaterial in den Poren der Siliziumoberfläche wird bei einer Temperatur zwischen ca. 1000°C und 1400°C getempert, um die in der Siliziumoberfläche erzeugten Poren wieder zu schließen. Dabei wird das Füllmaterial vom Silizium eingeschlossen. Die entstehende Si-Matrix weist hierbei einkristalline Eigenschaften auf, so dass bei Bedarf weitere Halbleiterprozesse darin ausgeführt werden können. Je nachdem, welches Füllmaterial ausgewählt wurde, können die Eigenschaften der Siliziumoberfläche geändert werden. Erfindungsgemäß können dabei Füllmaterialien jeder Art, insbesondere Nanopartikel, verwendet werden.

Die Unteransprüche zeigen bevorzugte Weiterbildungen der Erfindung.

Das Einfüllen des Füllmaterials in die Poren der Siliziumoberfläche erfolgt durch die Erzeugung von Vibrationen. Dies kann beispielsweise mechanisch mittels eines Rütteltischs o. Ä., oder mittels Ultraschall, erfolgen. Die Vibrationen werden vorzugsweise in zwei unterschiedliche Richtungen, insbesondere zwei zueinander senkrechte Richtungen, erzeugt. Alternativ kann das Füllen der Poren der Siliziumoberfläche mit dem Füllmaterial auch mittels überkritischem Kohlendioxid oder aus einer flüssigen Phase, z. B. einer Suspension oder einer Emulsion heraus durchgeführt werden.

Weiter bevorzugt wird die poröse Siliziumoberfläche mittels elektrochemischem Anodisieren hergestellt. Hierdurch kann eine besonders kostengünstige poröse Siliziumoberfläche erzeugt werden.

Besonders bevorzugt erfolgt das Tempern in einer Wasserstoffatmosphäre.

Weiter bevorzugt ist das Siliziumsubstrat eine einkristalline Silizium-Matrix. Hierdurch können die Nanopartikel in die einkristalline Silizium-Matrix eingebracht werden. Erfindungsgemäß kann somit ein einkristallines Siliziumsubstrat mit Einlagerungen erhalten werden. Dadurch können alle Vorteile eines monokristallinen Substrats erhalten werden.

Das einzubringende Füllmaterial ist besonders bevorzugt Kohlenstoff, insbesondere in Nanopartikelform, wie beispielsweise Graphit, oder eine Kohlenstoffverbindung, z.B. Kohlenwasserstoffe oder andere Kohlenstoffverbindungen mit Wasserstoff und/oder anderen Elementen, wie Sauerstoff, Stickstoff, Phosphor, Bor. Alternativ kann das Füllmaterial auch eine hochmolekulare aromatische oder aliphatische Kohlenstoffverbindung sein. Als Füllmaterial wird auch vorzugsweise eine beliebige Kombination verschiedener Materialien verwendet.

Besonders bevorzugt ist das in die poröse Siliziumoberfläche einzubringende Füllmaterial ein Dotierstoff zur Herstellung von p-leitenden oder n-leitenden Siliziumkarbid (SiC).

Gemäß einer weiteren bevorzugten Ausgestaltung der vorliegenden Erfindung ist das Porosifizieren und Auffüllen der porösen Siliziumoberfläche auf ein bestimmtes örtliches Gebiet begrenzt. Dadurch können insbesondere in-situ p- oder n-dotierte Schichten von Siliziumkarbid hergestellt werden. Auch kann dadurch ein Siliziumsubstrat, welches zwei oder mehrere Bereiche mit unterschiedlichem Füllmaterial aufweist, hergestellt werden.

### Zeichnung

Nachfolgend wird ein Ausführungsbeispiel der Erfindung unter Bezugnahme auf die begleitende Zeichnung im Detail beschrieben. In der Zeichnung ist:
- Figuren-1 bis 5: Schnittansichten verschiedener Verfahrensschritte eines Verfahrens zur Herstellung eines Siliziumsubstrats gemäß einem Ausführungsbeispiel der Erfindung.

### Ausführungsformen der Erfindung

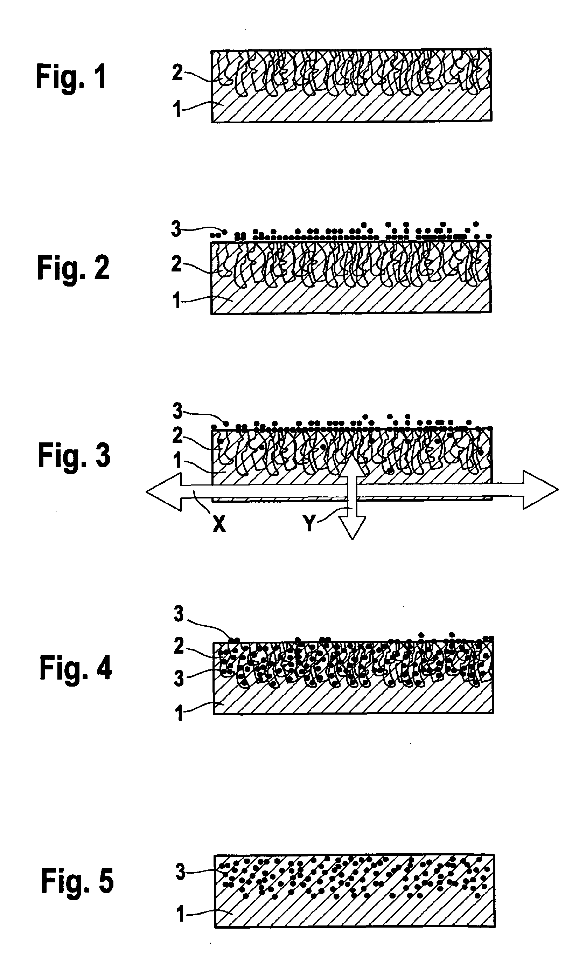

Nachfolgend wird unter Bezugnahme auf die Figuren 1 bis 5 ein Verfahren zur Herstellung eines Siliziumsubstrats 1 mit einer veränderten Oberfläche im Detail beschrieben.

Das Siliziumsubstrat 1 des Ausführungsbeispiels ist ein Siliziumwafer. Wie in Figur 1 gezeigt, wurde durch Porosizieren im Siliziumsubstrat 1 eine Vielzahl von Poren 2 gebildet. Die Poren 2 weisen eine unterschiedliche Breite und Tiefe auf und sind als Makroporen, Mesoporen und Nanoporen ausgebildet. Die Durchmesser liegen dabei vorzugsweise zwischen einigen µm (z.B.35 µm) bis 1 nm. Die Tiefe der Poren 2 liegt zwischen ca. 100 nm bis ca. 200 µm. Ein Durchmesser einer Pore 2 ist dabei über seine Tiefe nicht zwangsweise konstant. Nach dem ersten Schritt des Bereitstellens des Siliziumsubstrats werden die Poren 2 z.B. mittels elektrochemischem Anodisieren hergestellt, so dass die poröse Siliziumoberfläche entsteht.

Im nächsten Schritt wird ein einzubringendes Füllmaterial 3 auf die poröse Siliziumoberfläche aufgebracht. Das Füllmaterial ist in Nanopartikelform ausgebildet und weist vorzugsweise einen Durchmesser auf, welcher etwas kleiner ist als der kleinste erzeugte Durchmesser der Poren 2. Figur 3 zeigt schematisch durch die Doppelpfeile X und Y, dass mittels mechanischem Rütteln, beispielsweise mittels eines Rütteltischs o. Ä., die losen Füllmaterialien 3 in die Poren 2 eingebracht werden. Hierbei werden vorzugsweise mehrere Nanopartikel in eine Pore eingebracht. Wie in Figur 3 gezeigt, führt der Rütteltisch eine Bewegung parallel zur Längsrichtung der Poren 2 in Richtung des Doppelpfeils Y aus und eine zum Doppelpfeil Y senkrechte Bewegung in Richtung des Doppelpfeils X. Es wäre auch denkbar, dass weiterhin noch eine zusätzliche Bewegung in einer Richtung senkrecht zur Abbildungsebene durchgeführt wird. Die Bewegungen in X- und Y-Richtung können sich dabei überlagern oder auch nacheinander bzw. abwechselnd ausgeführt werden.

Figur 4 zeigt den Zustand, in welchem die Poren 2 jeweils mit einer gewissen Anzahl von Nanopartikeln 3 gefüllt wurden. Nanopartikel, welche sich noch auf der Oberfläche des Siliziumsubstrats 1 befinden, werden entfernt. Anschließend wird das mit den Nanopartikeln versehene Siliziumsubstrat bei einer Temperatur von ca. 1000°C bis ca. 1400°C getempert. Dadurch werden die im Siliziumsubstrat erzeugten Poren 2 wieder geschlossen. Die Temperung erfolgt vorzugsweise in einem Ofen, insbesondere unter einer Wasserstoffatmosphäre. Während der Temperaturbehandlung werden die Poren 2 der porösen Siliziumoberfläche wieder geschlossen, wobei die sich in den Poren 2 befindlichen Nanopartikel 3 eingeschlossen werden. Der Zustand des Siliziumsubstrats 1 nach dem Tempern ist in Figur 5 gezeigt.

Erfindungsgemäß ist es somit möglich, ein Siliziumsubstrat mit einer oder auch mehreren verschiedenen Komponenten herzustellen, welche sich unter normalen Umständen nicht bzw. nur unter unwirtschaftlichem Aufwand miteinander vermischen lassen würden. Insbesondere können in eine einkristalline Siliziummatrix Nanopartikel eingebracht werden, so dass eine neue Materialklasse herstellbar ist. Durch die Auswahl der Nanopartikel kann gezielt Einfluss auf die Eigenschaften des erzeugten Silizium-Nanopartikelprodukts genommen werden.

Als Nanopartikel werden vorzugsweise metallische Nanopartikel und/oder deren Oxide und/oder Karbide und/oder Nitride verwendet. Auch können als Nanopartikel beispielsweise Kohlenstoff zur Herstellung von SiC und/oder Materialien wie Tantal, Wolfram, Iridium, Zirkonium, Rhenium, Vanadium, Molybdän, Niob, Hafnium, Osmium, Scandium, Yttrium, Lutetium, Lawrencium, Titan, Chrom, Eisen, Ruthenium, Rhodium sowie deren Nitride und/oder Carbide verwendet werden. Auch ist es möglich, Seltene-Erden-Metall-Atome, beispielsweise für eine Realisierung von elektro-lumineszenten Siliziumschichten zu verwenden. Hierzu können beispielsweise alle Elemente der Hauptgruppe 3 des Periodensystems und insbesondere die Lanthanoiden (Ce bis Lu) verwendet werden.

Besonders bedeutsam ist die vorliegende Erfindung zur Herstellung von kristallinen SiC-Schichten, wobei insbesondere einkristalline SiC-Schichten hergestellt werden können. Kohlenstoff C oder ein Kohlenstoffträger kann beispielsweise in der Form von Graphit oder in der Form von Kohlenwasserstoffen oder anderen Kohlenstoffverbindungen mit Wasserstoff und/oder anderen Elementen, wie z.B. Sauerstoff, Stickstoff, Phosphor, Bor usw., eingebracht werden. Auch können auf diese Weise in-situ p-dotierte oder n-dotierte Schichten von SiC hergestellt werden.

Auch können Kohlenstoffverbindungen, welche in geeigneten Lösungsmitteln gelöst sind, eingebracht werden und beispielsweise durch Verdampfen des Lösungsmittels dauerhaft in den Poren der porösen Siliziumoberfläche abgeschieden werden. Beispielsweise können auf diese Weise C60-Partikel oder Karbon-Nanotubes oder Verbindungen solcher Partikel oder Tubes mit Wasserstoff gelöst in Benzol in den Poren 2 des porösen Siliziumsubstrats abgeschieden werden. Ebenso können hochmolekulare aromatische oder aliphatische Kohlenstoffverbindungen, z.B. Teer-artige Verbindungen, als Ausgangsstoffe eingesetzt werden, welche bei hohen Temperaturen einen so niedrigen Dampfdruck aufweisen, dass sie nicht oder nicht wesentlich während einer nachfolgenden Hochtemperaturbehandlung aus der Nanostruktur ausdampfen können, und folglich mit dem umgebenden Silizium der Nanostruktur reagieren. Als Füllmaterial können auch Stickstoff-Kohlenstoff-Verbindungen, sogenannte Nitril-artige Verbindungen, oder Cyanide (CN) oder Cyanamide (CN2) dienen, wobei es bei diesen Verbindungen bei einer Hochtemperaturbehandlung zu einem Aufbrechen der CN-Bindungen kommt. Während der so freigesetzte Kohlenstoff mit dem umgebenden Silizium weiterreagiert, kann der ebenso freigesetzte flüchtige Stickstoff die Nanostruktur noch weitgehend unreagiert wieder verlassen. Im Anschluss daran wird dann das Siliziumsubstrat 1 durch die Temperaturbehandlung getempert, um die Poren 2 der porösen Siliziumoberfläche zu schließen.

Somit kann erfindungsgemäß eine Art von Festkörperemulsion entstehen, deren Mischungsverhältnis durch die Porengröße, die Porenart und den Porenabstand sowie die Partikelgröße des Füllmaterials und die Menge des Füllmaterials definiert ist. Je nachdem, ob das poröse Siliziumsubstrat aus polykristallinem oder einkristallinem Silizium hergestellt wurde, kann mit einer geeigneten Parameterwahl erfindungsgemäß bestimmt werden, ob die in die poröse Siliziumoberfläche eingebrachten Partikel durch die Umlagerung von polykristallinem oder einkristallinem Silizium umschlossen werden. Auf diese Weise lassen sich auch Materialien miteinander verbinden, die sonst nur unter höchsten Schwierigkeiten miteinander vermengbar sind.

Erfindungsgemäß kann somit eine oberflächennahe einkristalline Siliziumschicht erreicht werden, die zu einem gewissen Anteil das eingebrachte Füllmaterial beinhaltet, was mit anderen Verfahren nicht bzw. nicht so kostengünstig möglich ist. Erfindungsgemäß kann somit beispielsweise kristallines oder amorphes Siliziumkarbid hergestellt werden. Es sei angemerkt, dass sich die Eigenschaft des erzeugten Materials durch die eingelagerten Nanopartikel stark beeinflussen lässt. Dadurch können beispielsweise chemisch und/oder mechanisch hoch resistente Oberflächen bereitgestellt werden. Des Weiteren können auch zusätzliche Dotierstoffe eingebracht werden, um beispielsweise in-situ p-leitendes oder n-leitendes Siliziumkarbid herzustellen.

Eine andere Verwendung des erfindungsgemäßen Verfahrens ist beispielsweise auch die Herstellung von Licht emittierendem Silizium zur Verwendung beispielsweise als LED durch gezielte Störung der Bandstruktur im Silizium. Dies kann beispielsweise dadurch erreicht werden, dass man Seltene-Erden-Atome, wie Erbium, in Nanopartikelform in das poröse Siliziumsubstrat 1 einbringt und dieses anschließend durchoxidiert.

Das erfindungsgemäße Verfahren ermöglicht somit die Herstellung neuer Materialien auf der Basis eines Siliziumsubstrats durch Porosizieren und Auffüllen der Poren mit einem oder mehreren unterschiedlichen Materialien, vorzugsweise in Nanopartikelgröße. Durch anschließendes Tempern werden die in die Poren eingebrachten Nanopartikel eingeschlossen. Das neuartige Siliziumsubstrat weist somit abhängig von den eingebrachten Partikeln unterschiedliche Eigenschaften auf. Das Einbringen von verschiedenen Partikeln kann beispielsweise auch auf der Siliziumoberfläche örtlich begrenzt sein, um auf einer Siliziumoberfläche beispielsweise mehrere unterschiedliche Bereiche unterschiedlicher Eigenschaften herzustellen.

## Patentansprüche

1. Verfahren zur Herstellung eines Siliziumsubstrats (1), umfassend die Schritte:
- Bereitstellen eines Siliziumsubstrats mit einer ebenen Siliziumoberfläche,
- Herstellen einer porösen Siliziumoberfläche mit einer Vielzahl von Poren (2),
- Aufbringen eines in das Silizium einzubringenden Füllmaterials (3), welches in Nanopartikelform eingebracht wird und einen Durchmesser aufweist, der kleiner als ein Durchmesser der Poren (2) ist,
- Einbringen des Füllmaterials (3) in die Poren (2),
- gegebenenfalls Entfernen von überflüssigem Füllmaterial (3) von der Siliziumoberfläche, und
- Tempern des Siliziumsubstrats (1) mit dem in den Poren (2) eingefüllten Füllmaterial (3) bei einer Temperatur zwischen 1000°C bis 1400°C, um die Poren (2) wieder zu schließen und das Füllmaterial (3) einzuschließen,
**dadurch gekennzeichnet, dass** das Einbringen des Füllmaterials (3) in die Poren (2) durch Erzeugen von Vibrationen erfolgt.

2. Verfahren nach Anspruch 1, **dadurch gekennzeichnet, dass** das Erzeugen von Vibrationen mittels Ultraschall und/oder mittels mechanischem Bewegen des Siliziumsubstrats, und/oder mittels überkritischem Kohlendioxid, und/oder aus der flüssigen Phase erfolgt.

3. Verfahren nach einem der vorhergehenden Ansprüche, **dadurch gekennzeichnet, dass** die Poren (2) der porösen Siliziumoberfläche mittels elektrochemischem Anodisieren hergestellt werden.

4. Verfahren nach einem vorhergehenden Ansprüche, **dadurch gekennzeichnet, dass** der Schritt des Temperns in einer Wasserstoffatmosphäre erfolgt.

5. Verfahren nach einem der vorhergehenden Ansprüche, **dadurch gekennzeichnet, dass** das Siliziumsubstrat (1) eine einkristalline Siliziummatrix ist.

6. Verfahren nach einem der vorhergehenden Ansprüche, **dadurch gekennzeichnet, dass** das einzubringende Füllmaterial Kohlenstoff und/oder eine Kohlenstoffverbindung ist.

7. Verfahren nach einem der vorhergehenden Ansprüche, **dadurch gekennzeichnet, dass** das einzubringende Füllmaterial (3) ein Gemisch aus zwei oder drei oder mehreren verschiedenen Materialien ist.

8. Verfahren nach einem der vorhergehenden Ansprüche, **dadurch gekennzeichnet, dass** die Poren (2) nur in einer ersten, einkristallinen Siliziumschicht des Siliziumsubstrats erzeugt werden.

9. Verfahren nach einem der vorhergehenden Ansprüche, **dadurch gekennzeichnet, dass** das einzubringende Füllmaterial (3) ein Dotierstoff zur Herstellung von p-leitendem oder n-leitendem Siliziumkarbid umfasst.

10. Verfahren nach einem der vorhergehenden Ansprüche, **dadurch gekennzeichnet, dass** in einem ersten Bereich des mit Poren (2) gebildeten Siliziumsubstrats (1) ein erstes Material eingefüllt wird und in einem zweiten Bereich des mit Poren erzeugten Siliziumsubstrats ein zweites Füllmaterial eingefüllt wird, welches unterschiedlich zum ersten Füllmaterial ist

11. Verfahren nach einem der vorhergehenden Ansprüche, **dadurch gekennzeichnet, dass** das einzubringende Füllmaterial (3) aus der Gruppe der Seltenen Erden ausgewählt ist und nach dem Tempern oxidiert wird.

## Claims

1. Method for producing a silicon substrate (1), said method comprising the following steps:
- providing a silicon substrate having a planar silicon surface,
- producing a porous silicon surface having a multiplicity of pores (2),
- applying a filling material (3), which is to be introduced into the silicon, is introduced in nanoparticle form and has a diameter which is smaller than a diameter of the pores (2),
- introducing the filling material (3) into the pores (2),
- if necessary, removing excess filling material (3) from the silicon surface, and
- heat-treating the silicon substrate (1), together with the filling material (3) which has been filled into the pores (2), at a temperature of between 1000°C and 1400°C, in order to reclose the pores (2) and enclose the filling material (3),
**characterized in that** the filling material (3) is introduced into the pores (2) by generating vibrations.

2. Method according to Claim 1, **characterized in that** vibrations are generated by means of ultrasound and/or by means of mechanical movement of the silicon substrate and/or by means of supercritical carbon dioxide and/or from the liquid phase.

3. Method according to either of the preceding claims, **characterized in that** the pores (2) of the porous silicon surface are produced by means of electrochemical anodizing.

4. Method according to one of the preceding claims, **characterized in that** the heat-treatment step is effected in a hydrogen atmosphere.

5. Method according to one of the preceding claims, **characterized in that** the silicon substrate (1) is a single-crystal silicon matrix.

6. Method according to one of the preceding claims, **characterized in that** the filling material to be introduced is carbon and/or a carbon compound.

7. Method according to one of the preceding claims, **characterized in that** the filling material (3) to be introduced is a mixture of two or three or a plurality of different materials.

8. Method according to one of the preceding claims, **characterized in that** the pores (2) are produced only in a first, single-crystal silicon layer of the silicon substrate.

9. Method according to one of the preceding claims, **characterized in that** the filling material (3) to be introduced comprises a dopant for producing p-conducting or n-conducting silicon carbide.

10. Method according to one of the preceding claims, **characterized in that** a first material is filled into a first region of the silicon substrate (1) formed with pores (2) and a second filling material which differs from the first filling material is filled into a second region of the silicon substrate generated with pores.

11. Method according to one of the preceding claims, **characterized in that** the filling material (3) to be introduced is selected from the group of the rare earth elements and is oxidized after the heat treatment.

## Revendications

1. Procédé de fabrication d'un substrat en silicium (1), comprenant les étapes suivantes :
- la préparation d'un substrat en silicium présentant une surface en silicium plane,
- la fabrication d'une surface en silicium poreuse comprenant une pluralité de pores (2),
- l'application d'un matériau de remplissage à introduire dans le silicium (3), qui est introduit sous forme nanoparticulaire et présente un diamètre qui est inférieur à un diamètre des pores (2),
- l'introduction du matériau de remplissage (3) dans les pores (2),
- éventuellement l'élimination du matériau de remplissage (3) en excès de la surface en silicium, et
- le recuit du substrat en silicium (1) contenant le matériau de remplissage (3) dans les pores (2) à une température comprise entre 1 000 °C et 1 400 °C, afin de refermer les pores (2) et d'enfermer le matériau de remplissage (3),
**caractérisé en ce que** l'introduction du matériau de remplissage (3) dans les pores (2) a lieu par génération de vibrations.

2. Procédé selon la revendication 1, **caractérisé en ce que** la génération de vibrations a lieu au moyen d'ultrasons et/ou au moyen d'un mouvement mécanique du substrat en silicium et/ou au moyen de dioxyde de carbone supercritique et/ou à partir de la phase liquide.

3. Procédé selon l'une quelconque des revendications précédentes, **caractérisé en ce que** les pores (2) de la surface en silicium poreuse sont formés par anodisation électrochimique.

4. Procédé selon l'une quelconque des revendications précédentes, **caractérisé en ce que** l'étape de recuit a lieu dans une atmosphère d'hydrogène.

5. Procédé selon l'une quelconque des revendications précédentes, **caractérisé en ce que** le substrat en silicium (1) est une matrice de silicium monocristalline.

6. Procédé selon l'une quelconque des revendications précédentes, **caractérisé en ce que** le matériau de remplissage à introduire est du carbone et/ou un composé de carbone.

7. Procédé selon l'une quelconque des revendications précédentes, **caractérisé en ce que** le matériau de remplissage à introduire (3) est un mélange de deux ou trois matériaux différents ou plus.

8. Procédé selon l'une quelconque des revendications précédentes, **caractérisé en ce que** les pores (2) ne sont générés que dans une première couche en silicium monocristalline du substrat en silicium.

9. Procédé selon l'une quelconque des revendications précédentes, **caractérisé en ce que** le matériau de remplissage à introduire (3) comprend un agent dopant pour la fabrication de carbure de silicium conducteur p ou conducteur n.

10. Procédé selon l'une quelconque des revendications précédentes, **caractérisé en ce qu'**une première zone du substrat en silicium (1) formé avec des pores (2) est remplie avec un premier matériau et une seconde zone du substrat en silicium formé avec des pores est remplie avec un second matériau de remplissage, qui est différent du premier matériau de remplissage.

11. Procédé selon l'une quelconque des revendications précédentes, **caractérisé en ce que** le matériau de remplissage à introduire (3) est choisi dans le groupe des terres rares et est oxydé après le recuit.
